## Europäisches Patentamt

## European Patent Office

## Office européen des brevets

(19)

(11) Veröffentlichungsnummer: **0 046 552**
**B1**

(12) # EUROPÄISCHE PATENTSCHRIFT

(45) Veröffentlichungstag der Patentschrift:
08.06.88

(51) Int. Cl.⁴: **H 01 L 27/10**, G 11 C 11/23

(21) Anmeldenummer: **81106345.2**

(22) Anmeldetag: **14.08.81**

(54) **Monolithisch integrierte Schaltung mit zu- und/oder abschaltbaren Schaltungsteilen.**

(30) Priorität: **27.08.80  DE 3032306**

(43) Veröffentlichungstag der Anmeldung:
**03.03.82 Patentblatt 82/9**

(45) Bekanntmachung des Hinweises auf die Patenterteilung:
**08.06.88 Patentblatt 88/23**

(84) Benannte Vertragsstaaten:
**BE FR GB IT NL**

(56) Entgegenhaltungen:
**US-A-3 528 064**
**US-A-3 634 927**
**US-A-3 940 740**
**US-A-4 190 849**

**PROCEEDINGS OF THE IEEE, Band 56, Nr. 2,
Februar 1968, Seiten 158-166; N.C. MacDONALD et
al.: "An electron beam activated switch and
associated memory"**

(73) Patentinhaber: **Siemens Aktiengesellschaft Berlin
und München, Wittelsbacherplatz 2, D-8000
München 2 (DE)**

(72) Erfinder: **Oldham, William G., Prof., 762, Colusa
Avenue, El Cerreto California 94530 (US)**

**Beschreibung**

Die Erfindung bezieht sich auf eine monolithisch integrierte Schaltung nach dem Oberbegriff des Anspruchs 1.

Eine Schaltung dieser Art ist beispielsweise aus den IEEE Transactions on Electron Devices, Vol. ED-26, Nr. 6, Juni 1979, S. 853 bis 860 bekannt. Dabei handelt es sich um eine 64 K-RAM-Speicherschaltung, bei der z. B. defekte Zeilen-, Spaltenleitungen oder Spaltendecoder von der übrigen Schaltung abgetrennt und durch mitintegrierte gleichartige Schaltungsteile ersetzt werden können. Die für eine solche Substitution erforderlichen Schaltelemente bestehen aus Polysilizium-Verbindungsgliedern, die bei Bedarf durch Bestrahlung mit einem Laserstrahl unterbrochen werden. Nachteilig ist jedoch die bei der Unterbrechung eines solchen Verbindungsgliedes auftretende thermische Belastung, die bei der Anwendung eines Laserstrahls nicht genau auf den Ort des Verbindungsgliedes beschränkt werden kann, sodaß die benachbarten Schaltungselemente in einer hinreichenden Entfernung von den Verbindungsgliedern angeordnet werden müssen, um unerwünschte Beschädigungen derselben durch den Laserstrahl zu vermeiden.

Der Erfindung liegt die Aufgabe zugrunde, eine Schaltung der eingangs genannten Art anzugeben, bei der zum Zu- bzw. Abschalten von einzelnen Schaltungsteilen Schaltelemente verwendet werden, die den Flächenbedarf der integrierten Schaltung nur geringfügig vergrößern. Diese Aufgabe wird erfindungsgemäß durch die in den Ansprüchen 1 und 2 angegebenen Merkmale gelöst.

Der mit der Erfindung erzielbare Vorteil liegt insbesondere darin, daß die zum Zu- bzw. Abschalten von Schaltungsteilen erforderlichen Schaltelemente mittels eines von einem herkömmlichen Elektronenstrahlschreiber erzeugten Elektronenstrahls in den erforderlichen Schaltzustand gebracht werden können, ohne daß eine unkontrollierbare Erwärmung ihrer Umgebung eintritt, die eine entsprechende Vergrößerung der benötigten Halbleiterfläche erfordern würde. Die Zu- und Abschaltung der einzelnen Schaltungsteile erfolgt vorteilhafterweise nach dem Aufbringen der Metallisierungsebene(n), so daß der Herstellungsprozeß einschließlich des Definierens der metallischen Belegungen von den genannten Zu- und Abschaltvorgängen vollständig unbeeinflußt bleibt. Außerdem ist für diese Vorgänge kein eigener Maskierungsschritt erforderlich, so daß die integrierte Schaltung einschließlich der einstellbaren Schaltelemente im Rahmen eines üblichen Herstellungsverfahrens erzeugt werden kann.

In den Ansprüchen 3 bis 9 sind bevorzugte Ausgestaltungen und Weiterbildungen der monolithisch integrierten Schaltung nach der Erfindung angegeben, während die Ansprüche 10 bis 12 auf vorteilhafte Verfahren zum Ab- bzw. Zuschalten eines Schaltungsteils von bzw. zu einer monolithisch integrierten Schaltung nach einem der Ansprüche 1 bis 9 gerichtet sind.

Die Erfindung wird nachfolgend an Hand der Zeichnung näher erläutert. Dabei zeigt:

Fig. 1    das Blockschaltbild einer nach der Erfindung ausgebildeten monolithisch integrierten Schaltung,

Fig. 2    eine Teilschaltung von Fig. 1,

Fig. 3    eine Schnittdarstellung der Teilschaltung nach Fig. 2 Fig. 4    eine erste alternative Ausbildung der Teilschaltung nach Fig. 2 im Querschnitt,

Fig. 5    eine zweite alternative Ausbildung der Teilschaltung nach Fig. 2 im Querschnitt,

Fig. 6    eine alternative Teilschaltung zu Fig. 2, Fig. 7    eine andere Teilschaltung von Fig. 1 und

Fig. 8    eine alternative Teilschaltung zu Fig. 7.

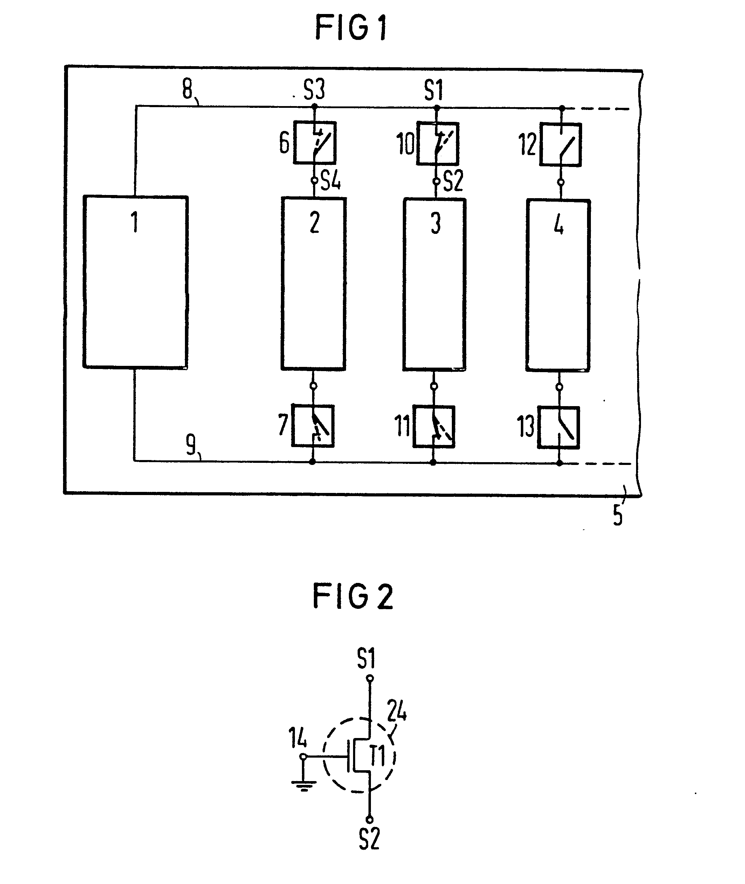

In Figur 1 ist eine aus dem ersten Schaltungsteil 1 und weiteren Schaltungsteilen 2 bis 4 bestehende Halbleiterschaltung auf einem dotiertem Halbleiterkörper 5, z. B. aus p-dotiertem Silizium, integriert. Der Schaltungsteil 2 ist in den gestrichelt gezeichneten Schaltstellungen der Schalter 6, 7 über Leitungen 8, 9 mit dem Schaltungsteil 1 verbunden. Die Schaltungsteile 3 und 4 entsprechen dem Schaltungsteil 2 nach Aufbau und Wirkungsweise und werden über die Schalter 10, 11 bzw. 12, 13 nur dann mit 1 verbunden, wenn die Funktion des Schaltungsteils 2, z. B. durch einen Kristallbaufehler, gestört ist. In diesem Fall wird der Schaltungsteil 2 zunächst durch den Schaltungsteil 3 substituiert, was durch ein Öffnen (ausgezogene Schaltstellung) der Schaltelemente 6 und 7 und durch ein Schließen (ausgezogene Schaltstellung) der normalerweise offenen Schalter 10 und 11 geschieht. Stellt sich danach heraus, daß auch der Schaltungsteil 3 defekt ist, so werden die Schalter 10 und 11 wieder geöffnet und die Schalter 12 und 13 geschlossen, wobei dann der Schaltungsteil 2 durch den Schaltungsteil 4 substituiert wird.

Das Schaltelement 10 der integrierten Schaltung nach Figur 1, das die Strecke zwischen den Schaltungspunkten S1 und S2 in der gestrichelten Schaltstellung unterbricht, wird durch einen in Figur 2 dargestellten Feldeffekttransistor T1 realisiert. Dieser sei bei einer p-Dotierung des Halbleiterkörpers 5 zunächst als eine N-Kanal-MIS-Struktur des Anreicherungstyps ausgebildet, wobei unter einer MIS-Struktur ganz allgemein eine Struktur verstanden wird, die einen Halbleiterkörper und einen durch eine elektrisch isolierende Schicht von diesem getrennte metallische Schicht umfaßt. Der Transistor T1 besitzt nach Figur 2 einen Sourceanschluß bzw. Drainanschluß S1 und einen Drainanschluß bzw. Sourceanschluß S2, die den in gleicher Weise bezeichneten Schaltungspunkten von Figur 1 entsprechen. Sein Gateanschluß 14 ist mit dem Bezugspotential der Schaltung verbunden.

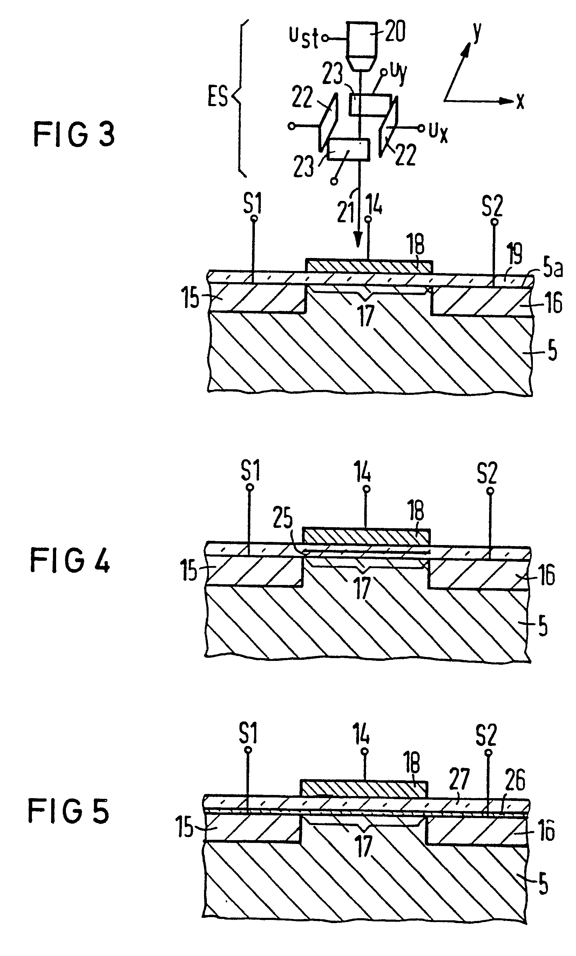

Figur 3 zeigt einen Querschnitt durch den Feldeffekttransistor T1. Wie hieraus hervorgeht, weist dieser zwei in den Halbleiterkörper 5 eingefügte n+-dotierte Gebiete 15 und 16 auf, die sich bis zu dessen Grenzfläche 5a nun erstrecken und die Source- und Drain-Gebiete darstellen. Zwischen diesen befindet sich an der Grenzfläche 5a der Kanalbereich 17, der von einem metallisch leitenden Gate 18 überdeckt ist, das durch eine Gate-Isolierschicht 19 von der Grenzfläche 5a getrennt ist. Die in Figur 3 eingezeichneten Anschlüsse 14, S1 und S2 entsprechen den in gleicher Weise bezeichneten Anschlüssen in Figur 2.

In Figur 3 ist weiterhin ein Elektronenstrahlschreiber ES angedeutet, der eine Elektronenkanone 20 aufweist. Ein von dieser ausgehender Elektronenstrahl 21 wird durch zwei Ablenksysteme mit den Plattenpaaren 22 und 23, die jeweils mit Spannungen $u_x$ und $u_y$ beschaltet sind, in den Richtungen x und y abgelenkt. Der scharf fokussierte Elektronenstrahl 21 überstreicht nun in Abhängigkeit von den Spannungen $u_x$ und $u_y$ die Oberfläche des Halbleiterkörpers 5 beispielsweise in einzelnen parallel zueinander verlaufenden Zeilen. Ein derartiger Elektronenstrahlschreiber, der lediglich an Stelle von elektrostatischen Ablenksystemen 22 und 23 mit magnetischen Ablenksystemen ausgestattet ist, kann der Zeitschrift Philips techn. Rundschau 35, 1975/76, Nr. 3, Seiten 72-84, insbesondere Seite 73, Bild 1, entnommen werden.

Bei einem solchen Elektronenstrahlschreiber wird der Elektronenstrahl 21 durch eine zugeführte Steuerspannung $u_{st}$ jeweils nur dann eingeschaltet, wenn er gerade den Kanalbereich 17 überstreicht.

Bei einer Stromdichte des Elektronenstrahls 21 z. B. 1 A/cm², einer Beschleunigungsspannung von etwa 25 KeV und einer lokalen Einwirkungsdauer von etwa $10^{-6}$s bilden sich in der Gate-Isolierschicht 19, die z. B. aus $SiO_2$ besteht, Ladungsträgerpaare, von denen jeweils die negativen Ladungsträger in den mit einem Bezugspotential beschalteten Halbleiterkörper 5 abfließen, während die positiven Ladungsträger in der Gate-Isolierschicht 19 verbleiben und diese positiv aufladen. Eine Aufladung annähernd gleicher Größe ergibt sich aber beispielsweise auch für eine Stromdichte von 100 A/cm² und einer Einwirkungsdauer von $10^{-8}$s bei gleichbleibender Beschleunigungsspannung. Hieraus ist ersichtlich, daß die Größe der positiven Aufladung im wesentlichen von dem Produkt aus Stromdichte und Einwirkungsdauer abhängt. Die genannten Zahlenwerte sind jedoch nur beispielsweise Angaben und können im Rahmen der Erfindung je nach der Größe der gewünschten positiven Aufladung variiert werden.

Durch die positive Aufladung der Gate-Isolierschicht 19 verschiebt sich die Einsatzspannung $U_t$ des N-Kanal-Transistors T1 des Anreicherungstyps von einem relativ hohen Wert (ohne positive Aufladung) auf einen relativ niedrigen Wert. Bei dem hohen Wert der Einsatzspannung befindet sich das durch T1 gebildete Schaltelement 10 in einem ersten, in Figur 1 gestrichelt gezeichneten Schaltzustand, in dem es die Punkte S1 und S2 voneinander trennt, während es nach einer Bestrahlung des Kanalbereichs 17 durch den Elektronenstrahl 21 in seinen zweiten Schaltzustand gelangt, in dem es die Schaltungspunkte S1 und S2 niederohmig miteinander verbindet. In Figur 2 wird die vorgenommene Bestrahlung des Kanalbereiches durch eine gestrichelte Umrandung 24 angedeutet.

Die Schaltelemente 11, 12 und 13 sind mit Vorteil entsprechend dem Schaltelement 10 aufgebaut. Wird der Elektronenstrahlschreiber ES dabei so betätigt, daß der Elektronenstrahl 21 beim Überstreichen der Kanalbereiche 17 der Schaltelemente 10 und 11 eingeschaltet wird, beim Überstreichen der Schaltelemente 12 und 13 jedoch nicht, so wird nur der Schaltungsteil 3 selektiv dem Schaltungsteil 1 zugeschaltet. Wird andererseits der Elektronenstrahl 21 nur beim Überstreichen der Schaltelemente 12 und 13 eingeschaltet, so wird nur der Schaltungsteil 4 selektiv dem Schaltungsteil 1 zugeschaltet.

Eine andere Methode der selektiven Verschiebung der Einsatzspannungen vorgegebener Schaltelemente, z. B. der Schaltelemente 10 und 11, besteht darin, daß zunächst die Einsatzspannungen $U_t$ aller Schaltelemente, d. h. im vorliegenden Fall der Schaltelemente 10 bis 13, durch eine gemeinsame Bestrahlung mit Röntgenstrahlen oder mit dem Elektronenstrahl eines Elektronenstrahlschreibers, dessen Stromdichte, Einwirkungsdauer und Beschleunigungsspannung in der beschriebenen Weise gewählt sind, auf einen relativ niedrigen Wert verschoben werden, und daß danach eine zusätzliche selektive Bestrahlung der Kanalbereiche derjenigen Schaltelemente, z. B. 12 und 13, deren ursprünglicher Schaltzustand nicht verändert werden sollte, mit einem Elektronenstrahl 21 sehr großer Leistungsdichte erfolgt. Diese Leistungsdichte wird so gewählt, daß sich die Gate-Isolierschicht 19 jeweils auf eine Temperatur von etwa 500 - 600°C erwärmt, wobei die gespeicherten positiven Ladungsträger in den Halbleiterkörper 5 abfließen, so daß die Gate-Isolierschicht wieder entladen und der ursprüngliche Wert der Einsatzspannung wieder erreicht wird. Hierbei kommen z. B. eine Stromdichte von 100 bis 500 A/cm² und eine lokale Einwirkungsdauer von $10^{-4}$s bei einer Beschleunigungsspannung von 25 KeV in Betracht.

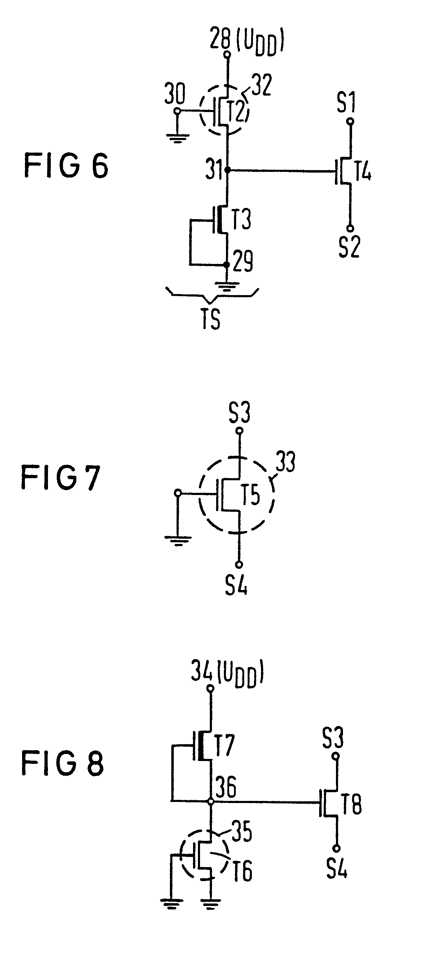

Gemäß Figur 4 können die Schaltelemente 10-13 auch als N-Kanal-Feldeffekttransistoren des Verarmungstyps realisiert werden, bei denen eine Polysiliziumschicht 25, die von äußeren Potentialen freigeschaltet ist und sich daher in einen Zustand der "floating" befindet, in die Gate-Isolierschicht 19 eingefügt ist. Alternativ hierzu kann die Gate-Isolierschicht der Schaltelemente 10 bis 13 auch aus zwei verschiedenen Teilschichten aufgebaut sein, z. B. aus einer $SiO_2$-Schicht 26 und einer darüber liegenden $Si_3N_4$-Schicht 27, wie in Figur 5 angedeutet ist. Hierbei erfolgt zunächst eine negative Aufladung der Polysiliziumschicht 25 oder der Grenzfläche zwischen den Teilschichten in herkömmlicher Weise, wie z. B. aus "A User's Handbook of Semiconductor Memories" von E.R. Hnatek, Verlag John Wiley & Sons, New York, 1977, Seiten 242 - 245 und 248, 249 oder aus den Siemens Forschungs- u. Entwicklungsberichten, Band 4 (1975), Nr. 6, Seiten 345-351, bekannt ist.

Die Schaltelemente 10 bis 13 erfahren hierdurch eine gemeinsame Verschiebung ihrer Einsatzspannungen $U_t$ auf einen hohen Wert, so daß sie sperren. Anschließend werden dann für eine selektive Anschaltung des Schaltungsteils 3 an den Schaltungsteil 1 lediglich die Kanalbereiche 17 in den Schaltelementen 10 und 11 mit dem Elektronenstrahl 21 bestrahlt, dessen Parameter wieder so gewählt sind, daß eine Erwärmung der Gate-Isolierschichten 19 bzw. 26 und 27 auf 500 - 600°C und damit eine Entladung derselben eintritt. Dabei verschieben sich die Einsatzspannungen $U_t$ der Schaltelemente 10 und 11 wieder auf den niedrigen Wert, den sie ohne die negative Aufladung aufweisen.

Bestehen die Schaltelemente 10 bis 13 bei einem n-leitenden Halbleiterkörper 5 aus P-Kanal-Transistoren des Anreicherungstyps, so werden ihre Gate-Isolierschichten entsprechend den Figuren 4 und 5 aufgebaut. Eine nichtselektive Aufbringung von negativen Ladungen ergibt dabei zunächst eine Verschiebung der absoluten Beträge der Einsatzspannungen $U_t$ der Schaltelemente 10 bis 13 auf niedrige Werte, während eine sich anschließende selektive Bestrahlung der Kanalbereiche 17 der Schaltelemente 12 und 13 mit einem energiereichen Elektronenstrahl 21 in der beschriebenen Weise zu einer Erwärmung und Entladung der betreffenden Gate-Isolierschichten und damit zu einer Rückverschiebung der Einsatzspannungen führt. Hieraus resultiert wieder eine selektive Anschaltung des Schaltungsteils 3 an den Schaltungsteil 1.

Bei Schaltelementen 10 bis 13, die aus P-Kanal-Feldeffekttransistoren des Verarmungstyps bestehen, werden zur selektiven Anschaltung des Schaltungsteils 3 zunächst alle Schaltelemente 10 bis 13 im Bereich ihrer Gate-Isolierschichten positiv aufgeladen, was durch eine Bestrahlung mit Röntgenstrahlen oder mit dem Elektronenstrahl 21 geschehen kann. Dies bewirkt eine Verschiebung der absoluten Beträge der Einsatzspannungen auf hohe Werte. Anschließend werden die Schaltelemente 10 und 11 einer selektiven Bestrahlung mit einem Elektronenstrahl 21 großer Energie zum Zwecke der Entladung ihrer Gate-Isolierschichten unterzogen.

In Fig. 6 ist eine andere Ausführung der Schaltelemente 10 bis 13 dargestellt. Hier ist der Feldeffekttransistor, dessen Einsatzspannung durch eine Bestrahlung mit dem Elektronenstrahl 21 verschoben werden kann, mit T2 bezeichnet und mit einem Lastelement, das aus einem Feldeffekttransistor T3 des Verarmungstyps besteht, dessen Gateanschluß mit seinem Sourceanschluß verbunden ist, in Serie geschaltet.

Diese Serienschaltung ist über den Drainanschluß 28 von T2 mit der Versorgungsspannung $U_{DD}$ und über den Sourceanschluß 29 von T3 mit dem Bezugspotential der Schaltung verbunden. Der Gateanschluß 30 von T2 liegt ebenfalls auf Bezugspotential. Der Verbindungspunkt 31 von T2 und T3 ist an den Gateanschluß eines Feldeffekttransistors T4 geführt, dessen Source-Drain-Kanal die Schaltungspunkte S1 und S2 von Fig. 1 wahlweise miteinander verbindet. In dem einen Schaltzustand von T2, der durch einen hohen Wert der Einsatzspannung gekennzeichnet ist, wird dem Gate von T4 das Bezugspotential zugeführt, so daß die Verbindung der Punkte S1 und S2 unterbrochen ist. Wird die Einsatzspannung von T2 auf einen niedrigen Wert verschoben, beispielsweise durch eine selektive Bestrahlung von T2 mit dem Elektronenstrahl 21, was in Fig. 6 durch eine gestrichelte Umrandung 32 angedeutet wird, so liegt das Gate von T4 etwa an der Versorgungsspannung $U_{DD}$, wobei T4 in den leitenden Zustand gelangt und die Punkte S1 und S2 niederohmig miteinander verbunden sind. Die Verschiebung der Einsatzspannung von T2 geschieht in der bereits anhand der Figuren 2 bis 5 beschriebenen Weise.

Das Schaltelement 6, das sich normalerweise in der in Fig. 1 gestrichelt gezeichneten Schaltstellung befindet, in der es die Schaltungspunkte S3 und S4 miteinander verbindet, wird mit Vorteil durch einen in Fig. 7 dargestellten Feldeffekttransistor T5 realisiert, der als P-Kanal-MIS-Struktur des Verarmungstyps ausgebildet ist. Sein Gateanschluß ist auf Bezugspotential gelegt. Die Einsatzspannung $U_t$ von T5 ist relativ niedrig, so daß der Source-Drain-Kanal von T5 sich im leitenden Zustand befindet. Der Querschnitt von T5 ist entsprechend den Figuren 3, 4 oder 5 ausgebildet. Erfolgt gemäß Fig. 3 eine Bestrahlung des Kanalbereichs 17 von T5 mit einem Elektronenstrahl 21, dessen Parameter wieder so gewählt sind, daß eine positive Aufladung der Gate-Isolierschicht von T5 erfolgt, so wird die Einsatzspannung auf einen relativ hohen Wert angehoben, wobei die Verbindung der Punkte S3 und S4 unterbrochen wird.

Damit wird dann der in Fig. 1 ausgezogen gezeichnete Schaltzustand des Schaltelements 6 erreicht. Wird auch das Schaltelement 7 (Fig. 1) durch eine entsprechende selektive Bestrahlung mit dem Elektronenstrahl 21 in diesen Schaltzustand gebracht, so wird der Schaltungsteil 2 von dem Schaltungsteil 1 abgeschaltet.

Bei einem N-Kanal-Transistor T5 vom Verarmungstyp, der entsprechend den Figuren 4 und 5 ausgebildet ist, kann wie bereits beschrieben eine negative Aufladung der Gate-Isolierschicht vorgenommen werden, um den zunächst niedrigen Wert der Einsatzspannung auf einen höheren Wert zu verschieben. Hierdurch gelangt das aus dem Transistor T5 bestehende Schaltelement 6 in den ausgezogen gezeichneten Schaltzustand, in dem es die Verbindung zwischen den Punkten S3 und S4 unterbricht. Die Aufbringung der negativen Ladung kann bei allen Schaltelementen gemeinsam erfolgen, wobei anschließend die jenigen Schaltelemente, deren Einsatzspannung nicht in dieser Richtung verschoben werden soll, selektiv mit einem Elektronenstrahl 21 hoher Energie bestrahlt werden, sodaß ihre Gate-Isolierschichten entladen werden. Werden die Einsatzspannungen der in den Schaltelementen 6 und 7 von Fig. 1 vorgesehenen Transistoren T5 in dieser Weise selektiv auf einen hohen Wert verschoben, so wird der Schaltungsteil 2 von dem Schaltungsteil 1 abgeschaltet.

Eine in N-Kanal-Technik ausgeführte Alternative zur Schaltung nach Figur 7 ist in Figur 8 dargestellt. Der Transistor, dessen Einsatzspannung durch eine selektive Bestrahlung mit einem Elektronenstrahl 21 in Richtung auf einen höheren Wert verschoben werden soll, ist in Figur 8 mit T6 bezeichnet. Sein Drainanschluß 36 ist über ein Lastelement, das aus einem Feldeffekttransistor T7 des Verarmungstyps mit untereinander verbundenen Source- und Gateanschlüssen besteht, en einen Anschluß 34 geführt, der mit der Versorgungsspannung $U_{DD}$ beschaltet ist. Der Sourceanschluß von T6 liegt ebenso wie sein Gateanschluß auf Bezugspotential. Der Drainanschluß 36 ist mit dem Gate eines Feldeffekttransistors T8 beschaltet, dessen Source-Drain-Kanal die Schaltungspunkte S3 und S4 von Figur 1 leitend verbindet oder nicht. Bei einem N-Kanal-Transistor-T6 des Anreicherungstyps liegt das Gate von T8 ohne eine Bestrahlung des Kanalbereiches von T6 mit einem Elektronenstrahl 21 wegen des gesperrten Zustandes von T6 etwa auf der Versorgungsspannung $U_{DD}$, sodaß S3 und S4 bei einer Ausbildung von T8 als N-Kanal-Transistor vom Anreicherungstyp leitend miteinander verbunden sind. Bei einer selektiven Bestrahlung (35 in Figur 8) von T6 mit einem Elektronenstrahl 21, durch den dessen Einsatzspannung in Richtung auf einen kleineren Wert verschoben wird, wird T6 leitend, sodaß das Gate von T8 auf das Bezugspotential gelegt wird und die leitende Verbindung der Punkte S3 und S4 unterbrochen wird.

Bei einer Ausbildung von T5 als N-Kanal-Transistor vom Anreicherungstyp werden, falls noch andere Transistoren des gleichen Typs auf dem Halbleiterkörper 5 mitintegriert sind, deren Einsatzspannungen nicht verschoben werden sollen, zunächst alle diese Transistoren in der bereits beschriebenen Weise mit einer negativen Ladung versehen, worauf dann diejenigen Transistoren, deren Einsatzspannungen nicht verschoben werden sollen, zusätzlich selektiv mit einem Elektronenstrahl 21 bestrahlt werden, der eine solche Energie besitzt, daß sich die Gate-Isolierschichten infolge einer hinreichend großen Erwärmung wieder entladen. Durch diese beiden Maßnahmen erfolgt eine selektive Verschiebung der Einsatzspannung von T5 in Richtung auf einen höheren Wert.

Wird T5 schließlich als P-Kanal-Transistor des Anreicherungstyps realisiert, so muß sein Gate negativ aufgeladen sein, um eine leitende Verbindung der Punkte S3 und S4 zu erreichen. Durch eine selektive Bestrahlung des Kanalbereiches von T5 mit einem Elektronenstrahl hoher Energie wird dann seine Einsatzspannung in Richtung auf einen größeren Wert verschoben, wodurch die leitende Verbindung zwischen S3 und S4 unterbrochen wird.

Die beschriebenen Schaltvorgänge auf dem Halbleiterkörper 5 können vorgenommen werden, nachdem die metallischen Belegungen aufgebracht worden sind und insbesondere nachdem an der Halbleiterschaltung Messungen bezüglich der Funktionsfähigkeit der einzelnen Schaltungsteile 1 bis 4 vorgenommen worden sind.

Ein bevorzugtes Anwendungsgebiet der integrierten Schaltung nach der Erfindung besteht bei Schaltungen, deren Parameter durch Zuschaltung oder Abschaltung von einzelnen Schaltungsteilen auf bestimmte, vorgegebene Werte eingestellt werden soll. Eine solche Einstellung von Schaltungsparametern wird auch als digitales Trimmen bezeichnet.

**Patentansprüche**

1. Monolithisch integrierte Schaltung mit einem oder mehreren jeweils über wenigstens ein Schaltelement zu- und/oder abschaltbaren Schaltungsteilen, dadurch gekennzeichnet, daß das Schaltelement (6, 7, 10 bis 13) einen mitintegrierten, als MIS-Struktur ausgebildeten Feldeffekttransistor (T1, T2, T5, T6) aufweist, dessen Gate-Isolierschicht (19) unter dem Einfluß eines den Kanalbereich (17) des Feldeffekttransistors (T1, T2, T5, T6) wenigstens teilweise abtastenden Elektronenstrahls (21) positiv aufladbar ist, wobei der ungeladene Zustand der Gate-Isolierschicht (19) einen hohen (niedrigen) Wert der Einsatzspannung und damit einen ersten Schaltzustand des Feldeffekttransistors (T1, T2, T5, T6) bestimmt, während der aufgeladene Zustand der Gate-Isolierschicht (19) einen niedrigen (hohen) Wert der Einsatzspannung und damit einen zweiten Schaltzustand des Feldeffekttransistors (T1, T2, T5, T6) bestimmt.

2. Monolithisch integrierte Schaltung mit einem oder mehreren jeweils über wenigstens ein Schaltelement zu- und/oder abschaltbaren

**0 046 552**

Schaltungsteilen, dadurch gekennzeichnet, daß das Schaltelement (6, 7, 10 bis 13) einen mitintegrierten, als MIS-Struktur ausgebildeten Feldeffekttransistor (T1, T2, T5, T6) aufweist, dessen Gate-Isolierschicht (19, 25, 26, 27) mit einer elektrischen Ladung versehen ist, die einen hohen (niedrigen) Wert der Einsatzspannung und damit einen ersten Schaltzustand des Feldeffekttransistors (T1, T2, T5, T6) bestimmt, und daß die Gate-Isolierschicht (19, 25, 26, 27) unter dem Einfluß eines den Kanalbereich (17) des Feldeffekttransistors (T1, T2, T5, T6) wenigstens teilweise abtastenden Elektronenstrahls (21) entladbar ist, wobei sie im entladenen Zustand einen niedrigen (hohen) Wert der Einsatzspannung und damit einen zweiten Schaltzustand des Feldeffekttransistors (T1 T2, T5, T6) bestimmt.

3. Monolithisch integrierte Schaltung nach Anspruch 1 oder 2, dadurch gekennzeichnet, daß der Source-Drain-Kanal des Feldeffekttransistors (T1, T5) eine den ihm zugeordneten Schaltungsteil (3, 2) mit der übrigen Schaltung (1) verbindende oder von dieser trennende Schaltstrecke bildet.

4. Monolithisch integrierte Schaltung nach Anspruch 1 oder 2, dadurch gekennzeichnet, daß der Feldeffekttransistor (T2, T6) in einer Transistorstufe (T2, T3, T6, T7) enthalten ist, deren Ausgang (31, 36) an das Gate eines weiteren Feldeffekttransistors (T4, T8) geführt ist, dessen Source-Drain-Kanal eine den zugeordneten Schaltungsteil (2, 3) mit der übrigen Schaltung (1) verbindende oder von dieser trennende Schaltstrecke bildet.

5. Monolithisch integrierte Schaltung nach einem der Ansprüche 1 bis 4, dadurch gekennzeichnet, daß die an- oder abschaltbaren Schaltungsteile (3, 4) zum Ersatz von gleichartigen funktionsgestörten Schaltungsteilen (2) der integrierten Schaltung dienen.

6. Monolithisch integrierte Schaltung nach einem der vorhergehenden Ansprüche, dadurch gekennzeichnet, daß in die Gate-Isolierschicht des Feldeffekttransistors (T1, T2, T5, T6) eine leitende Schicht (25) oder Störstellen eingefügt sind, die die Ladungszustände derselben stabilisieren.

7. Monolithisch integrierte Schaltung nach einem der Ansprüche 1 bis 5, dadurch gekennzeichnet, daß der Feldeffekttransistor (T1, T2, T5, T6) als MNOS-Transistor ausgebildet ist, dessen Gate-Isolierschicht aus einer $SiO_2$-Schicht (26) und einer darüberliegenden $Si_3N_4$-Schicht (27) besteht.

8. Verfahren zum Ab- bzw. Zuschalten eines Schaltungsteils (2, 3) von bzw. an eine monolithisch integrierte Schaltung nach einem der Ansprüche 1 bis 7, dadurch gekennzeichnet, daß der Elektronenstrahl (21) eines Elektronenstrahlschreibers (ES) derart abgelenkt wird, daß er selektiv den Kanalbereich (17) des Feldeffekttransistors (T1, T2, T5, T6) oder einen Teil davon überstreicht, und daß die Stromdichte, Einwirkungsdauer und Beschleunigungsspannung des Elektronenstrahls (21) so gewählt sind, daß er in der Gate-Isolierschicht (19, 26, 27) eine positive Ladung erzeugt, die den Wert der Einsatzspannung von einem ohne diese Aufladung bestehenden niedrigeren Wert auf einen höheren Wert verschiebt oder umgekehrt.

9. Verfahren zum Ab- bzw. Zuschalten eines Schaltungsteils (2, 3) von bzw. an eine monolithisch integrierte Schaltung nach einem der Ansprüche 1 bis 7, dadurch gekennzeichnet, daß bei einer Mehrzahl von mitintegrierten Feldeffekttransistoren (T1, T2, T5, T6) diese zunächst durch eine Bestrahlung mit Röntgenstrahlen oder mit einem von einem Elektronenstrahlschreiber (ES) erzeugten Elektronenstrahl (21), dessen Stromdichte, Einwirkungsdauer und Beschleunigungsspannung so gewählt sind, daß die Gate-Isolierschichten (19, 26, 27) der Feldeffekttransistoren (T1, T2, T5, T6) positiv aufgeladen werden, eine gemeinsame Verschiebung ihrer Einsatzspannungen erfahren und daß danach eine selektive Bestrahlung des Kanalbereiches (17) wenigstens eines der Feldeffekttransistoren (T1, T2, T5, T6) mit einem Elektronenstrahl (21) erfolgt, dessen Stromdichte, Einwirkungsdauer und Beschleunigungsspannung so gewählt sind, daß die Gate-Isolierschicht (19, 26, 27) dieses Feldeffekttransistors sich auf eine Temperatur erwärmt, bei der sie wieder entladen wird, so daß die Einsatzspannung dieses Feldeffekttransistors wieder ihren ursprünglichen Wert annimmt.

10. Verfahren zum Ab- bzw. Zuschalten eines Schaltungsteils von bzw. an eine monolithisch integrierte Schaltung nach einem der Ansprüche 1 bis 5 und einem der Ansprüche 6 oder 7, dadurch gekennzeichnet, daß bei einer Mehrzahl von mitintegrierten Feldeffekttransistoren (T1, T2, T5, T6) die Gate-Isolierschichten derselben zunächst in an sich bekannter Weise jeweils negativ aufgeladen werden, so daß die Feldeffekttransistoren (T1, T2, T5, T6) eine gemeinsame Verschiebung ihrer Einsatzspannungen erfahren und daß danach eine selektive Bestrahlung der Kanalbereiche (17) eines oder mehrerer dieser Feldeffekttransistoren (T1, T2, T5, T6) mit dem Elektronenstrahl (21) eines Elektronenstrahlschreibers (ES) erfolgt, dessen Stromdichte, Einwirkungsdauer und Beschleunigungsspannung so gewählt sind, daß die Gate-Isolierschichten dieses oder dieser Feldeffekttransistoren sich auf eine Temperatur erwärmen, bei der sie wieder entladen werden, so daß die zuletzt genannten Feldeffekttransistoren eine Einsatzspannung aufweisen, die dem ursprünglichen, ohne die aufgebrachte negativen Ladung vorhandenen Wert entspricht.

## Claims

1. A monolithic integrated circuit comprising one or more circuit components which can be connected and/or disconnected via at least one switching element, characterised in that the switching element (6, 7, 10 to 13) comprises a co-integrated field-effect transistor (T1, T2, T5, T6) which consists of an MIS-structure and whose gate-insulating layer (19) can be positively charged under the influence of an electron beam (21) which at least partially scans the channel zone (17) of the field-effect transistor (T1, T2, T5, T6), where the uncharged state of the gate-insulating layer (19) determines a high (low) value of the threshold voltage and thus a first switching state of the field-effect transistor (T1, T2, T5, T6), whereas the charged state of the gate-insulating layer (19) determines a low (high) value of the threshold voltage and thus a second switching state of the field-effect transistor (T1, T2, T5, T6).

2. A monolithic integrated circuit comprising one or more circuit components which can be connected and/or disconnected via at least one switching element, characterised in that the switching element (6, 7, 10 to 13) comprises a co-integrated field-effect transistor (T1, T2, T5, T6) which consists of an MIS-structure and whose gate-insulating layer (19, 25, 26, 27) is provided with an electric charge which governs a high (low) value of the threshold voltage and thus a first switching state of the field-effect transistor (T1, T2, T5, T6), and that the gate-insulating layer (19, 25, 26, 27) can be discharged under the influence of an electron beam (21) which at least partially scans the channel zone (17) of the field-effect transistor (T1, T2, T5, T6), where in the discharged state it governs a low (high) value of the threshold voltage and thus a second switching state of the field-effect transistor (T1, T2, T5, T6).

3. A monolithic integrated circuit as claimed in Claim 1 or 2, characterized in that the source-drain channel of the field-effect transistor (T1, T5) forms a switching path by which the assigned circuit component (3, 2) is connected to or separated from the remainder of the circuit (1).

4. A monolithic integrated circuit as claimed in Claim 1 or 2, characterised in that the field-effect transistor (T2, T6) is contained in a transistor stage (T2, T3, T6, T7) whose output (31, 36) leads to the gate of a further field-effect transistor (T4, T8) whose source-drain channel forms a switching path by which the assigned circuit component (2, 3) is connected to or separated from the remainder of the circuit (1).

5. A monolithic integrated circuit as claimed in one of Claims 1 to 4, characterised in that the connectable or disconnectable circuit component (3, 4) serve to replace functionally-disturbed circuit components (2), of the same type, in the integrated circuit.

6. A monolithic integrated circuit as claimed in one of the preceding Claims, characterised in that a conductive layer (25) or traps which stabilise the charge states of the gate-insulating layer of the field-effect transistor (T1, T2, T5, T6) are inserted therein.

7. A monolithic integrated circuit as claimed in one of Claims 1 to 5, characterised in that the field-effect transistor (T1, T2, T5, T6) is designed as a MNOS-transistor whose gate-insulating layer consists of a $SiO_2$-layer (26) and an overlying $Si_3N_4$-layer (27).

8. A method of disconnecting and connecting a circuit component (2, 3) from and to a monolithic integrated circuit as claimed in one of Claims 1 to 7, characterised in that the electron beam (21) of an electron beam recorder (ES) is deflected in such manner that it selectively passes over the channel zone (17) of the field-effect transistor (T1, T2, T5, T6) or a part thereof, and that the current density, reaction time and acceleration voltage of the electron beam (21) are selected to be such that in the gate-insulating layer (19, 26, 27) the electron beam generates a positive charge which shifts the value of the threshold voltage from a lower value, which occurs without this charge, to a higher value, or vice-versa.

9. A method of disconnecting and connecting a circuit component (2, 3) from and to a monolithic integrated circuit as claimed in one of Claims 1 to 7, characterised in that where a plurality of field-effect transistors (T1, T2, T5, T6) are co-integrated, these firstly undergo a common shift in their threshold voltages in that they are irradiated with X-rays or with an electron beam (21) generated by an electron beam recorder (ES) and whose current density, reaction time and acceleration voltage are selected to be such that the gate-insulating layers (19, 26, 27) of the field-effect transistors (T1, T2, T5, T6) are positively charged, and that then the channel zone (17) of at least one of the field-effect transistors (T1, T2, T5, T6) is selectively irradiated by an electron beam (21) whose current density, reaction time and acceleration voltage are selected to be such that the gate-insulating layer (19, 26, 27) of this field-effect transistor is heated to a temperature at which it is again discharged so that the threshold voltage of this field-effect transistor resumes its original value.

10. A method of disconnecting and connecting a circuit component from and to a monolithic integrated circuit as claimed in one of Claims 1 to 5 and one of Claims 6 or 7, characterised in that when a plurality of field-effect transistors (T1, T2, T5, T6) are co-integrated, the gate-insulating layers thereof are firstly each negatively charged in a manner known per se so that the field-effect transistors (T1, T2, T5, T6) undergo a common shift of their threshold voltages, and that then the channel zones (17) of one or more of these field-effect transistors (T1, T2, T5, T6) are selectively irradiated by the electron beam (21) of an electron beam recorder (ES), whose current density, reaction time and acceleration voltage are selected to be such that the gate-insulating layers of this or these field-effect transistors (S) are heated to a temperature at which they discharge again, so that the threshold voltage of the last-mentioned field-effect transistors corresponds to the original value which prevailed without the negative charge.

**Revendications**

1. Circuit intégré monolithique comportant une ou plusieurs parties de circuit pouvant être branchées et/ou débranchées respectivement par l'intermédiaire d'au moins un élément de commutation, caractérisé par le fait que l'élément de commutation (6, 7, 10 à 13) comporte un transistor à effet de champ (T1, T2, T5, T6) intégré simultanément et réalisé sous la forme d'une structure MIS et dont la couche d'isolant de grille (19) peut être chargée positivement sous l'influence d'un faisceau d'électrons (21) explorant au moins partiellement la zone (17) du canal du transistor à effet de champ (T1, T2, T5, T6), l'état non chargé de la couche d'isolant de grille (19) déterminant une valeur élevée (faible) de la tension de déclenchement et par conséquent un premier état de commutation du transistor à effet de champ (T1, T2, T5, T6), tandis que l'état chargé de la couche d'isolant de grille (19) détermine une valeur faible (élevée) de la tension de déclenchement et par conséquent un second état de commutation du transistor à effet de champ (T1, T2, T5, T6).

2. Circuit intégré monolithique comportant une ou plusieurs parties de circuit pouvant être branchées et/ou débranchées respectivement par l'intermédiaire d'au moins un élément de commutation, caractérisé par le fait que l'élément de commutation (6, 7, 10 à 13) comporte un transistor à effet de champ (T1, T2, T5, T6) intégré conjointement et realisé sous la forme d'une structure MIS, dans la couche d'isolant de grille (19, 25, 26, 27) et pourvu d'une charge électrique qui détermine une valeur élevée (faible) de la tension de déclenchement et par conséquent un premier état de commutation du transistor à effet de champ (T1, T2, T5, T6), et que la couche d'isolant de grille (19, 25, 26, 27) peut être déchargée sous l'influence d'un faisceau d'électrons (21) explorant au moins partiellement la zone (17) du canal du transistor à effet de champ (T1, T2, T5, T6), ladite couche déterminant, à l'état déchargé, une valeur faible (élevée) de la tension de déclenchement et par conséquent un second état de commutation du transistor à effet de champ (T1, T2, T5, T6).

3. Circuit intégré monolithique selon la revendication 1 ou 2, caractérisé par le fait que le canal source-drain du transistor à effet de champ (T1, T5) forme une voie de commutation reliant la partie de circuit (3, 2), qui lui est associée, au reste du circuit (1) ou bien séparant cette partie de circuit du reste du circuit.

4. Circuit intégré monolithique suivant la revendication 1 ou 2, caractérisé par le fait que le transistor à effet de champ (T2, T6) est contenu dans un étage à transistors (T2, T3, T6, T7), dont la sortie (31, 36) est raccordée à la grille d'un autre transistor à effet de champ (T4, T8), dont le canal source-drain forme une voie de commutation reliant la partie de circuit associée (2, 3) au reste du circuit (1) ou séparant cette partie de circuit du reste du circuit.

5. Circuit intégré monolithique selon l'une des revendications 1 à 4, caractérisé par le fait que les parties de circuit (3, 4), qui peuvent raccordées ou débranchées, servent à remplacer des parties (2) de même type, dont le fonctionnement est perturbé, du circuit intégré.

6. Circuit intégré monolithique suivant l'une des revendications précédentes, caractérisé par le fait que dans la couche d'isolant de grille du transistor à effet de champ (T1, T2, T5, T6) se trouvent insérés une couche conductrice (25) ou des défauts, qui stabilisent les états de charge de la couche.

7. Circuit intégré monolithique suivant l'une des revendications 1 à 5, caractérisé par le fait que le transistor à effet de champ (T1, T2, T5, T6) est réalisé sous la forme d'un transistor MNOS, dont la couche d'isolant de grille est constituée par une couche (26) de $SiO_2$ et par une couche (27) de $Si_3N_4$, disposée au-dessus de la précédente.

8. Procédé pour débrancher une partie de circuit (2, 3) d'un circuit intégré monolithique ou raccorder cette partie de circuit à ce circuit intégré, selon l'une des revendications 1 à 7, caractérisé par le fait qu'on déplace le faisceau d'électrons (21) d'un enregistreur à faisceau d'électrons (ES) de manière qu'il balaye de façon sélective la zone (17) du canal du transistor à effet de champ (T1, T2, T5, T6) ou une partie de cette zone, et on choisit la densité de courant, la durée d'action et la tension accélératrice du faisceau d'électrons (21) de manière que ce dernier produise dans la couche d'isolant de grille (19, 26, 27) une charge positive, qui décale la tension de déclenchement depuis une valeur inférieure présente sans cette charge, à une valeur supérieure ou inversement.

9. Procédé pour débrancher une partie de circuit (2, 3) d'un circuit intégré monolithique ou raccorder cette partie de circuit à ce circuit intégré, selon l'une des revendications 1 à 7, caractérisé par le fait que, dans le cas d'une multiplicité de transistors à effet de champ (T1, T2, T5, T6) intégrés conjointement, on réalise tout d'abord un décalage commun des tensions de déclenchement de ces transistors au moyen d'une irradiation à l'aide de rayons X ou bien à l'aide d'un faisceau d'électrons (21) produit par un enregistreur à faisceau d'électrons (ES) et dont la densité de courant, la durée d'action et la tension accélératrice sont choisies de manière que les couches d'isolant de grille (19, 26, 27) du transistor à effet de champ (T1, T2, T5, T6) soient chargées positivement, et qu'on réalise ensuite une irradiation sélective de la zone (17) du canal d'au moins l'un des transistors à effet de champ (T1, T2, T5, T6) avec un faisceau d'électrons (21), dont on choisit la densité de courant, la durée d'action et la tension accélératrice de manière que la couche d'isolant de grille (19, 26, 27) de ce transistor à effet de champ s'échauffe à une température pour laquelle elle est à nouveau déchargée, de sorte que la tension de déclenchement de ce transistor à effet de champ prend à nouveau sa valeur initiale.

10. Procédé pour débrancher une partie de circuit d'un circuit intégré monolithique ou pour raccorder une partie de circuit à un circuit intégré monolithique suivant l'une des revendications 1 à 5 et suivant l'une des revendications 6 ou 7, caractérisé par le fait que, dans le cas d'une multiplicité de transistors à effet de champ (T1, T2, T5, T6), on charge tout d'abord négativement les couches d'isolant de grille de ces transistors, d'une manière connue en soi, de manière à provoquer un décalage commun des tensions de déclenchement des transistors à effet de champ (T1, T2, T5, T6), et qu'on réalise une irradiation sélective des zones (17) des canaux d'un ou de plusieurs de ces transistors à effet de champ (T1, T2, T5, T6) avec le faisceau d'électrons (21) d'un enregistreur à faisceau d'électrons (ES), dont on choisit la densité de courant, la durée d'action et la tension accélératrice de manière que les couches d'isolant de grille de ce ou ces transistors à effet de champ s'échauffent à une température, pour laquelle elles sont à nouveau déchargées, de sorte que les transistors à effet de champ indiqués en dernier lieu possèdent une tension de déclenchement qui correspond à la valeur initiale présente sans l'application de la charge négative.

# FIG 1

# FIG 2

FIG 3

FIG 4

FIG 5

FIG 6

28 (U_DD)

30

32

T2

S1

31

T4

T3

29

S2

TS

FIG 7

S3

33

T5

S4

FIG 8

34 (U_DD)

T7

S3

36

T8

35

S4

T6